# EUROPEAN PATENT SPECIFICATION

(11) **EP 1 967 504 B1**
(45) Date of publication and mention of the grant of the patent: **02.05.2012**
(21) Application number: 07830365.8
(22) Date of filing: 23.10.2007
(51) Int. Cl.: C04B 35/622, C04B 35/632, H01G 4/12, H01G 4/30, H05K 3/46

(54) **SLURRY COMPOSITION FOR CERAMIC GREEN SHEET AND METHOD FOR PRODUCING THE SAME, AND MULTILAYER CERAMIC ELECTRONIC COMPONENT AND METHOD FOR MANUFACTURING THE SAME**
SCHLICKERZUSAMMENSETZUNG FÜR EINE KERAMIK-GRÜNFOLIE UND VERFAHREN ZU DEREN HERSTELLUNG SOWIE MEHRSCHICHTIGES KERAMIK-ELEKTRONIK-BAUTEIL UND VERFAHREN ZU DESSEN HERSTELLUNG
COMPOSITION DE BARBOTINE POUR FEUILLE DE CÉRAMIQUE CRUE ET SON PROCÉDÉ DE FABRICATION, ET COMPOSANT ÉLECTRONIQUE CÉRAMIQUE MULTICOUCHES ET SON PROCÉDÉ DE FABRICATION

(30) Priority: 24.10.2006 JP 2006288503
(43) Date of publication of application: 10.09.2008
(73) Proprietor: Murata Manufacturing Co. Ltd., Nagaokakyo-shi, Kyoto 617-8555 (JP)
(72) Inventor: KISHIDA, Kazuo, 10-1, Higashikotari 1-chome, Nagaokakyo-shi Kyoto-fu 617-8555 (JP)
(74) Representative: Zimmermann, Tankred Klaus
(86) International application number: PCT/JP2007/070631
(87) International publication number: WO 2008/050757

(56) References cited:
- EP-A1- 0 479 219
- WO-A2-03/029166
- JP-A- 06 096 993
- JP-A- 07 187 809
- JP-A- 2004 319 527
- JP-A- 2005 139 034
- JP-A- 2006 225 228
- US-A- 4 536 535
- US-A- 5 766 528

## Description

### Technical Field

The present invention relates to slurry compositions for ceramic green sheets and methods for producing the compositions and multilayer ceramic electronic components and methods for producing the components. In particular, this invention relates to an organic solvent-based slurry composition for ceramic green sheets which includes a ceramic raw powder containing boron and an alkaline earth metal and a binder component and a method for producing the composition and a multilayer ceramic electronic component produced using the slurry composition and a method for producing the component.

### Background Art

Ceramic green sheets are formed when, for example, multilayer ceramic electronic components such as multilayer ceramic substrates and multilayer ceramic capacitors are produced, and a slurry composition is prepared to form such ceramic green sheets. The ceramic green sheets are formed by forming the slurry composition into sheets.

To form ceramic green sheets of excellent quality, it is important that the slurry composition remain ungelled. The slurry composition, however, often tends to gel with time. Techniques for preventing gelling of a slurry composition are discussed in, for example, Japanese Unexamined Patent Application Publication Nos. 6-96993 (Patent Document 1) and 7-187809 (Patent Document 2).

Patent Document 1 discusses a technique of preparing a slurry composition by adding an acrylic acid polymer binder to a mixture of a solvent, a ceramic raw powder containing an alkaline earth metal, and a chelating agent that forms a complex with the alkaline earth metal.

Patent Document 1 assumes that the alkaline earth metal contained in the ceramic raw powder is the causative substance of gelling. To prevent gelling, therefore, the chelating agent is added to form a complex with the alkaline earth metal.

In Patent Document 1, water is used in examples as the solvent added to the slurry composition, and chelating agents such as ethylenediaminetetraacetic acid (EDTA), diethyleneaminepentaacetic acid (DTPA), nitrilotriacetic acid (NTA), and triethylenetetrahexaacetic acid (TTHA) are used.

Patent Document 2, on the other hand, discusses a technique of preparing a slurry composition by adding poly(vinyl alcohol) to a mixture of water, a ceramic raw powder containing boron oxide, and a polyalcohol.

Patent Document 2 assumes that a reaction of poly(vinyl alcohol) with the boron oxide contained in the ceramic raw powder is the cause of gelling. To prevent gelling, the polyalcohol is added to the ceramic raw powder containing boron oxide in advance before poly(vinyl alcohol) is added.

In Patent Document 2, polyalcohols such as D-glucitol and D-mannitol are used.

The slurry compositions discussed in Patent Documents 1 and 2 both contain water as a solvent.

Another attempt has been made to prepare a slurry composition using a ceramic raw powder containing boron, a butyral binder component such as poly(vinyl butyral), and an organic solvent. In this case, however, boron leaches from the ceramic raw powder into the organic solvent, causing a crosslinking reaction with the butyral binder component. This often leads to gelling of the slurry composition and increased viscosity through a process from a step of dispersion treatment for preparing the slurry composition to a step of forming ceramic green sheets. Such a composition cannot be used to stably form ceramic green sheets of excellent quality.

One approach to the above problem is the application of the gelling-preventing techniques discussed in Patent Documents 1 and 2.

However, the slurry compositions subjected to the gelling-preventing measures discussed in Patent Documents 1 and 2 both contain water as a solvent. These measures cannot be applied to prevent gelling of an organic solvent-based slurry composition because the chelating agent added to prevent gelling in Patent Document 1 and the polyalcohol added to prevent gelling in Patent Document 2 both have low solubility in organic solvents.

Japanese Unexamined Patent Application Publication No. 2005-139034 (Patent Document 3) proposes a slurry composition that can be a solution to the above problem. The slurry composition discussed in Patent Document 3 contains a boron-containing ceramic raw powder, a butyral binder component, such as poly(vinyl butyral), which has hydroxy groups, an organic solvent, and a β-diketone, serving as a chelating agent, and the content of the β-diketone is 0.5 to 5.0 times by weight that of boron.

The slurry composition discussed in Patent Document 3 can be favorably prevented from gelling or having increased viscosity because boron leaching into the organic solvent reacts selectively with the β-diketone, which is compatible with the organic solvent, so that a crosslinking reaction of boron with the butyral binder component can be inhibited.

For the slurry composition discussed in Patent Document 3, however, the content of the β-diketone, serving as a chelating agent, is specified on the basis of the content of boron; actually, other ionized components leaching from the ceramic raw powder are also responsible for gelling, and its cause is not limited to boron. In addition, any alkaline earth metal contained in the ceramic raw powder also leaches as one such ionized component. Patent Document 3, nevertheless, gives no consideration to the presence of the alkaline earth metal, and the content of the β-diketone specified therein is not necessarily satisfactory.

Furthermore, the butyral binder component, such as a poly(vinyl butyral), contained as a binder component in the slurry composition discussed in Patent Document 3 has relatively low degreasability. If ceramic green sheets formed of the slurry composition are used to produce a multilayer ceramic electronic component, they tend to suffer delamination and also require extended firing time which may raise costs.
Patent Document 1: Japanese Unexamined Patent Application Publication No. 6-96993
Patent Document 2: Japanese Unexamined Patent Application Publication No. 7-187809
Patent Document 3: Japanese Unexamined Patent Application Publication No. 2005-139034

### Summary of the Invention

An object of the present invention is to provide an organic solvent-based slurry composition for ceramic green sheets which includes a ceramic raw powder containing boron and an alkaline earth metal and a binder component, which can be favorably prevented from gelling, and which has superior degreasability, and also provide a method for producing the composition.

This object is achieved by a slurry composition of claim 1. The present invention provides a ceramic green sheet formed of the above slurry composition.

The present invention provides a multilayer ceramic electronic component produced using the above slurry composition and a method for producing the component.

First, this invention is directed to a slurry composition for ceramic green sheets. The slurry composition according to this invention includes a ceramic raw powder containing boron and an alkaline earth metal, a binder component, and an organic solvent. To solve the above technical problems, the slurry composition includes an acrylic binder component as the binder component and further includes a β-diketone as a chelating agent. The content of the β-diketone is 0.020 to 0.040 times by weight the total content of boron and the alkaline earth metal in the ceramic raw powder. The β-diketone is acetylacetone.

This invention is further directed to a ceramic green sheet formed of the above slurry composition for ceramic green sheets.

This invention is further directed to a method for producing the above slurry composition for ceramic green sheets. The production method according to this invention includes the steps of dispersing the ceramic raw powder containing boron and the alkaline earth metal and the β-diketone, serving as a chelating agent, and dispersing the acrylic binder component.

This invention is further directed to the following method for producing a multilayer ceramic electronic component and the following multilayer ceramic electronic component.

In a first aspect, the method for producing a multilayer ceramic electronic component according to this invention includes the steps of preparing a plurality of ceramic green sheets according to this invention, laminating the ceramic green sheets on top of one another to form an unsintered ceramic laminate, and firing the unsintered ceramic laminate.

In a second aspect, the method for producing a multilayer ceramic electronic component according to this invention includes the steps of preparing first ceramic green sheets according to this invention, preparing a second ceramic green sheet containing a ceramic powder that is not substantially sintered at the sintering temperature of the first ceramic green sheets, laminating the first ceramic green sheets on top of one another with the second ceramic green sheet provided on one of the first ceramic green sheets to form an unsintered composite laminate, and firing the unsintered composite laminate.

In the method for producing a multilayer ceramic electronic component according to the second aspect, the second ceramic green sheet may be provided as an outermost layer of the unsintered composite laminate, and the method may further include a step of removing an unsintered outer constraining layer derived from the second ceramic green sheet provided as the outermost layer after the step of firing the unsintered composite laminate.

The multilayer ceramic electronic component according to this invention includes a plurality of ceramic layers stacked on top of one another, and the ceramic layers are formed by sintering ceramic green sheets according to this invention.

The multilayer ceramic electronic component according to this invention may further include a constraining layer provided on one of the ceramic layers. The constraining layer contains a ceramic powder that is not substantially sintered at the sintering temperature of the ceramic green sheets.

### Advantages

This invention can provide a slurry composition that is favorably prevented from gelling or having increased viscosity. This is because boron and the alkaline earth metal leaching into the organic solvent react selectively with the β-diketone, which is compatible with the organic solvent, so that a crosslinking reaction of boron and the alkaline earth metal with the acrylic binder component can be inhibited.

In addition, the slurry composition according to this invention can reliably achieve a gelling-preventing effect because the content of the β-diketone, serving as a chelating agent, is specified as a weight ratio with respect to the total content of components responsible for gelling, including not only boron but also the alkaline earth metal.

Furthermore, the slurry composition according to this invention, including the acrylic binder component, has higher degreasability than one including a butyral binder component. With the slurry composition, therefore, delamination can be suppressed, and firing time can be reduced.

The use of the slurry composition according to this invention therefore allows production of a multilayer ceramic substrate of excellent quality.

In the method for producing a multilayer ceramic electronic component according to this invention, particularly, a multilayer ceramic electronic component with high accuracy in terms of dimension and shape can be produced by preparing first ceramic green sheets according to this invention, preparing a second ceramic green sheet containing a ceramic powder that is not substantially sintered at the sintering temperature of the first ceramic green sheets, laminating the first ceramic green sheets on top of one another with the second ceramic green sheet provided on one of the first ceramic green sheets to form an unsintered composite laminate, and firing the unsintered composite laminate.

### Brief Description of Drawings

Fig. 1 is a set of sectional views for illustrating a first embodiment of a method for producing a multilayer ceramic substrate as an example of a multilayer ceramic electronic component using a slurry composition according to this invention.
Fig. 2 is a sectional view showing surface-mounted components 11 and 12 mounted on a multilayer ceramic substrate 1 shown in Fig. 1(3).
Fig. 3 is a set of sectional views for illustrating a second embodiment of the method for producing a multilayer ceramic substrate as an example of a multilayer ceramic electronic component using the slurry composition according to this invention.
Fig. 4 is a sectional view for illustrating a third embodiment of the method for producing a multilayer ceramic substrate as an example of a multilayer ceramic electronic component using the slurry composition according to this invention.

### Reference Numerals

1 and 1a: multilayer ceramic substrate
2, 2a, and 2b: composite laminate
3: ceramic layer
4: ceramic laminate
5: outer constraining layer
9: interlayer constraining layer

### Best Modes for Carrying Out the Invention

A slurry composition for ceramic green sheets according to this invention is produced as follows.

First, a ceramic raw powder containing boron and an alkaline earth metal, an organic solvent, and a β-diketone, serving as a chelating agent, are sufficiently mixed until the ceramic raw powder and the β-diketone are dispersed in the organic solvent.

An acrylic binder component is then added to the above mixture, which is further mixed, thus preparing an intended slurry composition.

The acrylic binder component may be added in multiple steps after the ceramic raw powder and the β-diketone are dispersed in the organic solvent. If necessary, other additives such as a plasticizer may be added to the slurry composition.

If the β-diketone is added at the same time as or after the addition of the acrylic binder component, however, a crosslinking reaction of boron and the alkaline earth metal with the acrylic binder component proceeds to some extent before the β-diketone works, thus causing gelling.

In the production method according to this invention, the content of the β-diketone is 0.020 to 0.040 times by weight that of boron and the alkaline earth metal in the ceramic raw powder. The content of boron and the alkaline earth metal is expressed on an element basis. The β-diketone used is acetylacetone.

The acrylic binder component used may be, for example, an acrylic acid ester copolymer, a methacrylic acid ester copolymer, an alkyl acrylate copolymer, or an alkyl methacrylate copolymer.

Next, experiment examples carried out to determine the specification conditions of the slurry composition for ceramic green sheets and the method for producing the composition according to this invention will be described.

### Experiment Example 1

A ceramic raw powder containing boron and an alkaline earth metal was prepared. This ceramic raw powder included 40% by weight of alumina powder and 60% by weight of glass (SiO₂:Al₂O₃:CaO:B₂O₃ = 59:6:27:8). Then, 200 g of the ceramic raw powder containing boron and the alkaline earth metal (the total content of boron (B) and the alkaline earth metal (Ca) was 26.2 g), 3.0 g of a dispersant, 5.0 g of a plasticizer, and acetylacetone, used as the β-diketone, were subjected to primary mixing in 200 g of a toluene-ethanol (1:1) mixed solvent for 16 hours. Samples were prepared having different weight ratios of acetylacetone to the total content of boron and the alkaline earth metal in the ceramic raw powder, as shown in the column "Acetylacetone content" of Table 1.

Next, 30 g of an acrylic binder solution containing 50% by weight of acrylic component was added to the primary mixtures. The mixtures were then subjected to secondary mixing for 16 hours, thus preparing slurry compositions for the samples.

The slurry compositions thus prepared were formed into sheets with an area of 100 mm x 100 mm and a thickness of 30 µm, thus forming substrate ceramic green sheets.

In addition, 2.0 g of a dispersant and 5.0 g of a plasticizer were added to 200 g of alumina powder, and they were subjected to primary mixing in 200 g of a toluene-ethanol (1:1) mixed solvent for one hour. Then, an acrylic binder solution containing 50% by weight of acrylic component was added to the primary mixture so that the acrylic component was contained in an amount of 13% by weight of the amount of alumina powder, and they were subjected to secondary mixing for 16 hours, thus preparing a slurry composition for constraining layers. The slurry composition thus prepared was formed into sheets with an area of 100 mm x 100 mm and a thickness of 100 µm, thus forming constraining-layer alumina green sheets.

Thirty substrate ceramic green sheets were laminated on top of one another, and three constraining-layer alumina green sheets were laminated on each of the top and bottom of the laminate. In this way, ceramic laminates including capacitors (distance between electrodes for providing capacitance: 15 µm) were formed. These ceramic laminates were fired at a firing temperature of 900 °C for 30 minutes to produce multilayer ceramic substrates. The samples were evaluated for capacitance variation. The results are shown in Table 1.

**Table 1**

| Sample No. | Acetylacetone content (weight ratio) | Slurry viscosity (mPa·s) | Surface roughness (µm) | Capacitance variation (3C V; %) |
|---|---|---|---|---|
| 1 | 0 | 220 | 4.82 | 9.33 |
| 2 | 0.015 | 180 | 3.25 | 6.21 |
| 3 | 0.020 | 101 | 0.31 | 1.28 |
| 4 | 0.030 | 94 | 0.18 | 0.92 |
| 5 | 0.040 | 98 | 0.26 | 1.12 |
| 6 | 0.060 | 215 | 3.84 | 6.51 |

Table 1 shows that Samples 3 to 5, having acetylacetone contents within the range of 0.020 to 0.040 times by weight, had sufficiently low slurry viscosity, low surface roughness, and small capacitance variations at 3C V, namely, less than 2%. These results demonstrate that the gelling-preventing effect of acetylacetone was sufficiently exerted.

In contrast, Samples 1 and 2, having acetylacetone contents of less than 0.020 times by weight, had surface roughnesses of more than 3 µm and capacitance variations of more than 5% at 3C V. This is because the amount of acetylacetone was insufficient to mask leached ions, thus leading to gelling and a tendency to increased viscosity.

In addition, Sample 6, having an acetylacetone content of more than 0.040 times by weight, showed a tendency to increased viscosity and had a surface roughness of more than 3 µm and a capacitance variation of more than 5% at 3C V. This is because acetylacetone combined not only with the leached ions but also with other elements contained in the ceramic raw powder to form a network.

### Experiment Example 2

A ceramic raw powder containing boron and an alkaline earth metal was prepared. This ceramic raw powder included 40% by weight of alumina powder and 60% by weight of glass (SiO₂:Al₂O₃:CaO:B₂O₃ = 59:6:27:8). Then, 200 g of the ceramic raw powder containing boron and the alkaline earth metal (the total content of boron (B) and the alkaline earth metal (Ca) was 26.2 g), 3.0 g of a dispersant, 5.0 g of a plasticizer, and acetylacetone, used as the β-diketone, were subjected to primary mixing in 200 g of a toluene-ethanol (1:1) mixed solvent for 16 hours. At this time, different weight ratios of acetylacetone to the total content of boron and the alkaline earth metal in the ceramic raw powder were selected, as shown in the column "Acetylacetone content" of Table 2.

Next, an acrylic binder solution containing 50% by weight of acrylic component or a butyral binder solution containing 20% by weight of butyral component was added to the primary mixtures in different amounts, as shown in Table 2. The mixtures were then subjected to secondary mixing for 16 hours, thus preparing slurry compositions for samples.

The slurry compositions thus prepared were formed into sheets with an area of 100 mm x 100 mm and a thickness of 30 µm, thus forming substrate ceramic green sheets.

In addition, 2.0 g of a dispersant and 5.0 g of a plasticizer were added to 200 g of alumina powder, and they were subjected to primary mixing in 200 g of a toluene-ethanol (1:1) mixed solvent for one hour. Then, an acrylic binder solution containing 50% by weight of acrylic component was added to the primary mixture so that the acrylic component was contained in an amount of 13% by weight of the amount of alumina powder, and they were subjected to secondary mixing for 16 hours, thus preparing a slurry composition for constraining layers. The slurry composition thus prepared was formed into sheets with an area of 100 mm x 100 mm and a thickness of 100 µm, thus forming constraining-layer alumina green sheets.

Thirty substrate ceramic green sheets were laminated on top of one another, and three constraining-layer alumina green sheets were laminated on each of the top and bottom of the laminate. In this way, ceramic laminates including capacitors (distance between electrodes for providing capacitance: 15 µm) were formed. These ceramic laminates were fired at a firing temperature of 900 °C for 30 minutes to produce multilayer ceramic substrates. The multilayer ceramic substrates of the samples were evaluated for delamination by scanning acoustic microscopy (C-SAM) and polished section observation. Table 2 shows the number of samples that caused delamination among ten samples for each type.

**Table 2**

| Sample No. | Type of binder | Binder content (% by weight) | Acetylacetone content (weight ratio) | Delamination (number of samples) |
|---|---|---|---|---|
| 11 | Acrylic | 11.0 | 0.020 | 0 |
| 12 | Acrylic | 13.0 | 0.030 | 0 |
| 13 | Acrylic | 15.0 | 0.030 | 0 |
| 14 | Acrylic | 17.0 | 0.040 | 0 |
| 15 | Butyral | 8.0 | 0.020 | 1 |
| 16 | Butyral | 10.0 | 0.030 | 2 |
| 17 | Butyral | 12.0 | 0.040 | 3 |

Table 2 shows that Samples 11 to 14, containing the acrylic binder, caused no delamination, whereas Samples 15 to 17, containing the butyral binder, caused delamination even though their acetylacetone contents fell within the range of 0.020 to 0.040 times by weight.

The slurry composition for ceramic green sheets according to this invention is advantageous for use in the production of a multilayer ceramic electronic component as described below.

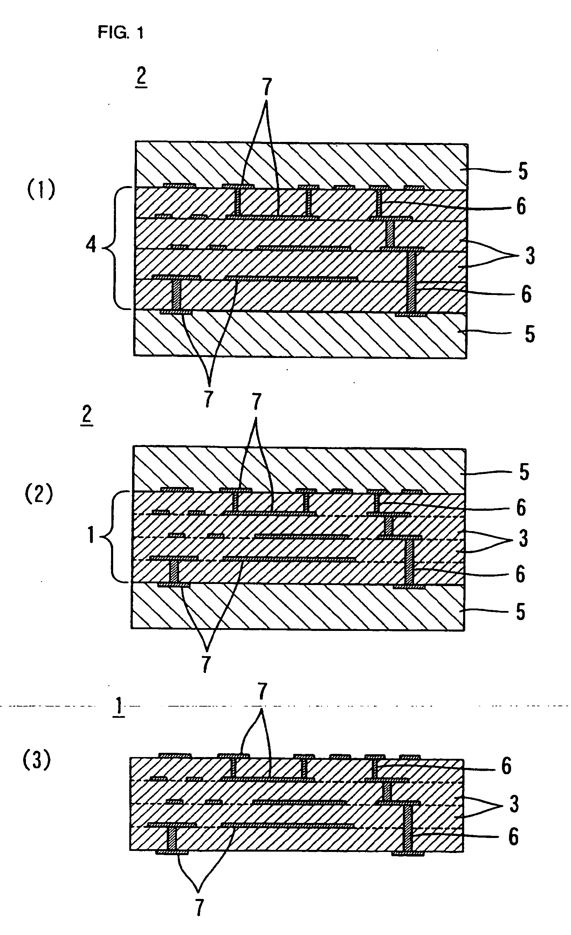

Fig. 1 illustrates a method for producing a multilayer ceramic substrate as an example of a multilayer ceramic electronic component. Fig. 1(3) is a sectional view of a resultant multilayer ceramic substrate 1. The multilayer ceramic substrate 1 is produced through the steps shown in Figs. 1(1) and 1(2).

Referring to Fig. 1(1), first, an unsintered composite laminate 2 is formed. This unsintered composite laminate 2 includes a ceramic laminate 4 having a multilayer structure of ceramic layers 3 and outer constraining layers 5 provided on the two main surfaces of the ceramic laminate 4 to constitute the outermost layers of the unsintered composite laminate 2.

To form the unsintered composite laminate 2, first ceramic green sheets that are to constitute the ceramic layers 3 and second ceramic green sheets that are to constitute the outer constraining layers 5 are prepared. The first ceramic green sheets are formed of the slurry composition according to this invention. The second ceramic green sheets contain a ceramic powder that is not substantially sintered at the sintering temperature of the first ceramic green sheets. The ceramic powder used is, for example, alumina powder or a zirconia powder.

Next, unsintered interlayer connection conductors 6 are formed by forming through-holes in some of the first ceramic green sheets and filling them with conductive paste. In addition, unsintered in-plane conductors 7 are formed on main surfaces of some of the first ceramic green sheets by printing with conductive paste. The in-plane conductors 7 positioned on the outer surfaces of the ceramic laminate 4 may instead be formed on the second ceramic green sheets, which are to constitute the outer constraining layers 5.

Next, the first ceramic green sheets are laminated in a predetermined order to form the unsintered ceramic laminate 4. In the unsintered ceramic laminate 4, the first ceramic green sheets constitute the ceramic layers 3. In addition, the second ceramic green sheets are provided on the two main surfaces of the unsintered ceramic laminate 4 to form the composite laminate 2, with the ceramic laminate 4 held between the outer constraining layers 5. The composite laminate 2 is then pressed in the lamination direction.

Next, the composite laminate 2 is fired at a temperature at which the outer constraining layers 5 are not sintered but the unsintered ceramic layers 3 and the unsintered interlayer connection conductors 6 and in-plane conductors 7 are sintered. The state after the firing is shown in Fig. 1(2), where elements equivalent to those shown in Fig. 1(1) are denoted by the same reference numerals.

As a result of the firing step, the ceramic layers 3, the interlayer connection conductors 6, and the in-plane conductors 7, constituting the ceramic laminate 4, are sintered, but the outer constraining layers 5 of the composite laminate 2 are not substantially sintered. Thus, the ceramic laminate 4 is sintered between the outer constraining layers 5, so that the multilayer ceramic substrate 1 is obtained. The contrast between Figs. 1(1) and 1(2) shows that the fired multilayer ceramic substrate 1 has been prevented from contracting in the main-surface direction as compared with the unsintered ceramic laminate 4 under the effect of the outer constraining layers 5. In the thickness direction, the multilayer ceramic substrate 1 has contracted relatively largely as compared with the unsintered ceramic laminate 4.

Next, the unsintered outer constraining layers 5 are removed from the fired composite laminate 2, thus obtaining the sintered multilayer ceramic substrate 1, as shown in Fig. 1(3). The unsintered outer constraining layers 5 can readily be removed by sand blasting, for example, because they have become porous due to volatilization of organic components contained before the firing.

In the above embodiment, the multilayer ceramic substrate 1 is produced using the outer constraining layers 5 to achieve high accuracy in terms of dimension and shape. If this advantage is not required, the multilayer ceramic substrate 1 may be produced without using the outer constraining layers 5. Alternatively, only one outer constraining layer 5 may be provided on either main surface of the ceramic laminate 4.

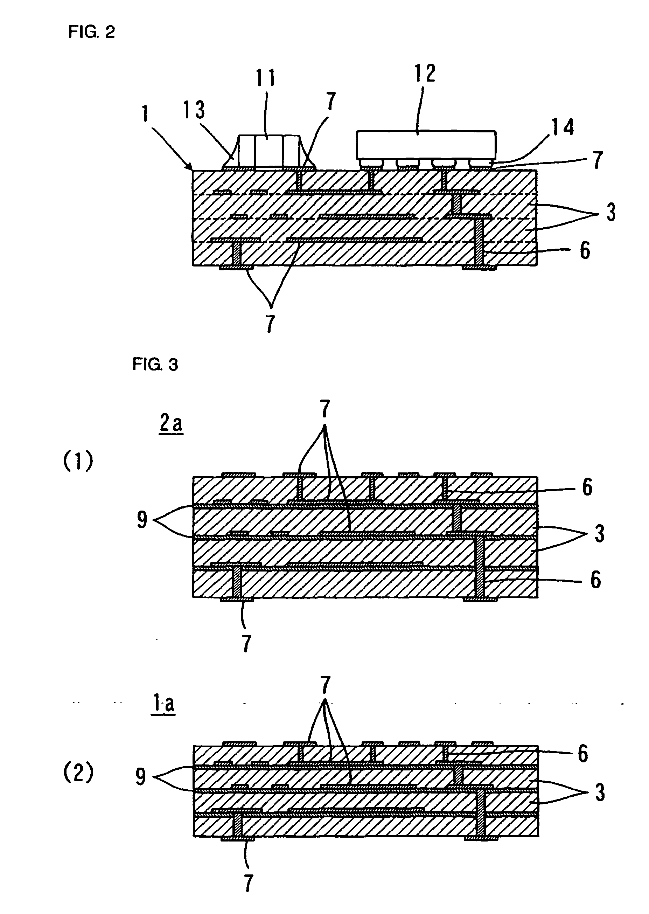

Referring to Fig. 2, surface-mounted components 11 and 12 are optionally mounted on the top main surface of the resultant multilayer ceramic substrate 1. The surface-mounted component 11 may be, for example, a chip capacitor electrically connected to the in-plane conductors 7 positioned on the outer surface with solder joints 13. The other surface-mounted component 12 may be, for example, a semiconductor chip electrically connected to the in-plane conductors 7 positioned on the outer surface with solder bumps 14.

Fig. 3 illustrates another embodiment of the method for producing a multilayer ceramic substrate as an example of a multilayer ceramic electronic component. Fig. 3(2) is a sectional view of a resultant multilayer ceramic substrate 1a, and Fig. 3(1) is a sectional view of an unsintered composite laminate 2a prepared for production of the multilayer ceramic substrate 1a. In Fig. 3, elements equivalent to those shown in Fig. 1 are denoted by the same reference numerals, and no redundant description will be given.

Referring to Fig. 3(1), the unsintered composite laminate 2a includes unsintered ceramic layers 3 and unsintered interlayer constraining layers 9 formed along the interfaces between the ceramic layers 3. As in the embodiment shown in Fig. 1, the ceramic layers 3 are constituted of the first ceramic green sheets, which are formed of the slurry composition according to this invention. Like the outer constraining layers 5 of the embodiment shown in Fig. 1, the interlayer constraining layers 9 are constituted of the second ceramic green sheets, which contain a ceramic powder that is not substantially sintered at the sintering temperature of the first ceramic green sheets. The interlayer constraining layers 9 are thinner than the ceramic layers 3.

The second ceramic green sheets, which are to constitute the interlayer constraining layers 9, may be formed in advance before they are laminated on the first ceramic green sheets, or may be directly formed on the first ceramic green sheets by thick-film printing.

Next, the interlayer connection conductors 6 and the in-plane conductors 7 are formed by the same method as used in the embodiment shown in Fig. 1, followed by a laminating step.

The unsintered composite laminate 2a thus formed is fired to provide the multilayer ceramic substrate 1a shown in Fig. 3(2). In the firing step, the composite laminate 2a is fired at a temperature at which the unsintered ceramic layers 3 and the unsintered interlayer connection conductors 6 and in-plane conductors 7 are sintered but the ceramic powder contained in the interlayer constraining layers 9 is not substantially sintered.

As a result of the firing step, some of the glass component contained in the ceramic layers 3 diffuses or flows into the interlayer constraining layers 9, thus binding together the ceramic powder contained in the interlayer constraining layers 9. In the firing step, the interlayer constraining layers 9 do not substantially contract because the ceramic powder itself is not substantially sintered in the interlayer constraining layers 9. The interlayer constraining layers 9 thus provide a contraction-suppressing effect on the ceramic layers 3 to suppress contraction of the ceramic layers 3 in the main-surface direction. The multilayer ceramic substrate 1a thus produced can achieve high accuracy in terms of dimension and shape. In this embodiment, the interlayer constraining layers 9 are not removed after the firing step but are left in the multilayer ceramic substrate 1.

In the above embodiment, the interlayer constraining layers 9 do not have to be provided at all interfaces between the ceramic layers 3. In addition, a surface constraining layer may be formed on at least one main surface of the composite laminate 2a using the same material as the interlayer constraining layers 9. In the firing step, some of the glass component contained in the ceramic layers 3 also diffuses or flows into the surface constraining layer, thus binding together the powder contained in the surface constraining layer. In this case, the surface constraining layer is not removed.

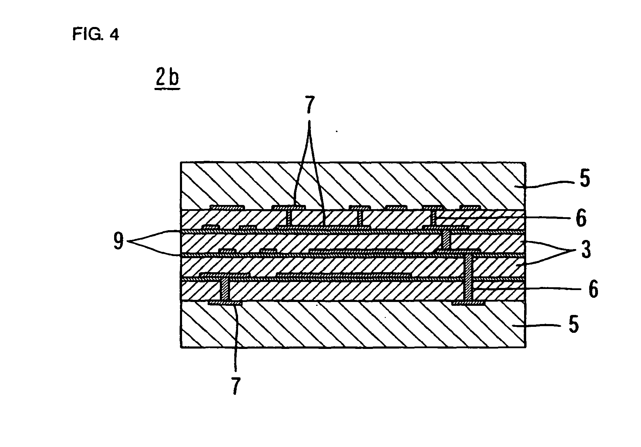

Fig. 4 illustrates another embodiment of the method for producing a multilayer ceramic substrate as an example of a multilayer ceramic electronic component. Fig. 4 is a diagram corresponding to Figs. 1(1) and 3(1). In Fig. 4, elements equivalent to those shown in Figs. 1(1) and 3(1) are denoted by the same reference numerals, and no redundant description will be given.

An unsintered composite laminate 2b shown in Fig. 4 is characterized in that it includes both the outer constraining layers 5 and the interlayer constraining layers 9. The rest of its structure is substantially the same as those of the embodiments shown in Fig. 1 and 3.

In the embodiment shown in Fig. 4, the interlayer constraining layers 9 are not removed after the firing step, but the outer constraining layers 5 are removed.

This embodiment provides a multilayer ceramic substrate with higher accuracy in terms of dimension and shape.

## Claims

1. A slurry composition for ceramic green sheets which comprises a ceramic raw powder containing boron and an alkaline earth metal, an acrylic binder component, a β-diketone, serving as a chelating agent, and an organic solvent,
wherein the content of the β-diketone is 0.020 to 0.040 times by weight the total content of boron and the alkaline earth metal in the ceramic raw powder, and
wherein the β-diketone is acetylacetone.

2. A ceramic green sheet formed of the slurry composition according to Claim 1.

3. A method for producing the slurry composition for ceramic green sheets according to Claim 1, comprising the steps of:
dispersing the ceramic raw powder containing boron and the alkaline earth metal and the β-diketone, serving as a chelating agent; and
dispersing the acrylic binder component.

4. A method for producing a multilayer ceramic electronic component, comprising the steps of:
preparing a plurality of ceramic green sheets according to Claim 2;
laminating the ceramic green sheets on top of one another to form an unsintered ceramic laminate; and
firing the unsintered ceramic laminate.

5. A method for producing a multilayer ceramic electronic component, comprising the steps of:
preparing first ceramic green sheets according to Claim 2;
preparing a second ceramic green sheet containing a ceramic powder that is not substantially sintered at the sintering temperature of the first ceramic green sheets;
laminating the first ceramic green sheets on top of one another with the second ceramic green sheet provided on one of the first ceramic green sheets to form an unsintered composite laminate (2); and
firing the unsintered composite laminate (2) at a temperature at which the second ceramic green sheet is not sintered.

6. The method for producing a multilayer ceramic electronic component according to Claim 5, wherein the second ceramic green sheet is provided as an outermost layer of the unsintered composite laminate (2), and the method further comprises a step of removing an unsintered outer constraining layer (5) derived from the second ceramic green sheet provided as the outermost layer after the step of firing the unsintered composite laminate (2).

7. A multilayer ceramic electronic component comprising a plurality of ceramic layers (3) stacked on top of one another, wherein the ceramic layers (3) are formed by sintering ceramic green sheets according to Claim 2.

8. A multilayer ceramic electronic component comprising a plurality of ceramic layers (3) stacked on top of one another, wherein the ceramic layers (3) are formed by sintering ceramic green sheets according to Claim 2, and the multilayer ceramic electronic component further comprises a constraining layer (5; 9) provided on one of the ceramic layers (3), the constraining layer (5; 9) containing a ceramic powder that is not substantially sintered at the sintering temperature of the ceramic green sheets.

## Patentansprüche

1. Eine Schlickerzusammensetzung für Keramikgrünschichten, die ein Keramikrohpulver aufweist, das Bor und ein Alkalierdmetall, eine Acrylbindemittelkomponente, ein β-Diketon, das als chelatbildendes Mittel dient, und ein organisches Lösungsmittel enthält,
wobei der Gehalt des β-Diketons 0,020 bis 0,040mal das Gewicht des Gesamtgehalts von Bor und dem Alkalierdmetall in dem Keramikrohpulver ist, und
wobei das β-Diketon Acetylaceton ist.

2. Eine Keramikgrünschicht, die aus der Schlickerzusammensetzung gemäß Anspruch 1 gebildet ist.

3. Ein Verfahren zum Herstellen der Schlickerzusammensetzung für Keramikgrünschichten gemäß Anspruch 1, das folgende Schritte aufweist:
Dispergieren des Keramikrohpulvers, das Bor und das Alkalierdmetall und das β-Diketon enthält, das als ein chelatbildendes Mittel dient; und
Dispergieren der Acrylbindemittelkomponente.

4. Ein Verfahren zum Herstellen einer Mehrschicht-Keramik-Elektronikkomponente, das folgende Schritte aufweist:
Vorbereiten einer Mehrzahl von Keramikgrünschichten gemäß Anspruch 2;
Laminieren der Keramikgrünschichten aufeinander, um ein ungesintertes Keramiklaminat zu bilden; und
Brennen des ungesinterten Keramiklaminats.

5. Ein Verfahren zum Herstellen einer Mehrschicht-Keramik-Elektronikkomponente, das folgende Schritte aufweist:
Vorbereiten erster Keramikgrünschichten gemäß Anspruch 2;
Vorbereiten einer zweiten Keramikgrünschicht, die ein Keramikpulver enthält, das bei der Sintertemperatur der ersten Keramikgrünschichten im Wesentlichen nicht gesintert wird;
Laminieren der ersten Keramikgrünschichten aufeinander, wobei die zweite Keramikgrünschicht auf einer der ersten Keramikgrünschichten vorgesehen ist, um ein ungesintertes zusammengesetztes Laminat (2) zu bilden; und
Brennen des ungesinterten zusammengesetzten Laminats (2) bei einer Temperatur, bei der die zweite Keramikgrünschicht nicht gesintert wird.

6. Das Verfahren zum Herstellen einer Mehrschicht-Keramik-Elektronikkomponente gemäß Anspruch 5, bei der die zweite Keramikgrünschicht als eine äußerste Schicht des ungesinterten zusammengesetzten Laminats (2) vorgesehen ist, und das Verfahren ferner einen Schritt des Entfernens einer ungesinterten äußeren Beschränkungsschicht (5) aufweist, die von der zweiten Keramikgrünschicht abgeleitet ist, die als die äußerste Schicht vorgesehen ist, nach dem Schritt des Brennens des ungesinterten zusammengesetzten Laminats (2).

7. Eine Mehrschicht-Keramik-Elektronikkomponente, die eine Mehrzahl von Keramikschichten (3) aufweist, die aufeinander gestapelt sind, wobei die Keramikschichten (3) gebildet werden durch Sintern von Keramikgrünschichten gemäß Anspruch 2.

8. Eine Mehrschicht-Keramik-Elektronikkomponente, die eine Mehrzahl von Keramikschichten (3) aufweist, die aufeinander gestapelt sind, wobei die Keramikschichten (3) gebildet werden durch Sintern von Keramikgrünschichten gemäß Anspruch 2, und die Mehrschicht-Keramik-Elektronikkomponente ferner eine Beschränkungsschicht (5; 9) aufweist, die auf einer der Keramikschichten (3) vorgesehen ist, wobei die Begrenzungsschicht (5; 9) ein Keramikpulver enthält, das bei der Sintertemperatur der Keramikgrünschichten im Wesentlichen nicht gesintert wird.

## Revendications

1. Composition de barbotine pour feuilles de céramique crues qui comprend une poudre de céramique brute contenant du bore et un métal alcalino-terreux, un composant de liant acrylique, une β-dicétone servant d'agent chélatant, et un solvant organique,
dans laquelle la teneur de la β-dicétone est de 0,020 à 0,040 fois en poids la teneur totale du bore et du métal alcalino-terreux de la poudre de céramique brute, et
dans laquelle la β-dicétone est de l'acétylacétone.

2. Feuille de céramique crue fabriquée à partir de la composition de barbotine selon la revendication 1.

3. Procédé de fabrication de la composition de barbotine pour feuilles de céramique crues selon la revendication 1, comprenant les étapes consistant à :
disperser la poudre de céramique brute contenant du bore et le métal alcalino-terreux et la β-dicétone servant d'agent chélatant ; et
disperser le composant de liant acrylique.

4. Procédé de fabrication d'un composant électronique céramique multicouches, comprenant les étapes consistant à :
préparer une pluralité de feuilles de céramique crues selon la revendication 2 ;
stratifier les feuilles de céramique crues les unes sur les autres pour former un stratifié céramique non fritté ; et
chauffer le stratifié céramique non fritté.

5. Procédé de fabrication d'un composant électronique céramique multicouches, comprenant les étapes consistant à :
préparer des premières feuilles de céramique crues selon la revendication 2 ;
préparer une deuxième feuille de céramique crue contenant une poudre de céramique qui n'est pas sensiblement frittée à la température de frittage des premières feuilles de céramique crues ;
stratifier les premières feuilles de céramique crues les unes sur les autres avec la deuxième feuille de céramique crue placée sur l'une des premières feuilles de céramique crues pour former un stratifié composite non fritté (2) ; et
chauffer le stratifié composite non fritté (2) à une température à laquelle la deuxième feuille de céramique crue n'est pas frittée.

6. Procédé de fabrication d'un composant électronique céramique multicouches selon la revendication 5, dans lequel la deuxième feuille de céramique crue constitue la couche la plus externe du stratifié composite non fritté (2), le procédé comprenant en outre une étape d'élimination d'une couche de contrainte externe non frittée (5) dérivée de la deuxième feuille de céramique crue constituant la couche la plus externe après l'étape de chauffage du stratifié composite non fritté (2).

7. Composant électronique céramique multicouches comprenant une pluralité de couches céramiques (3) empilées les unes sur les autres, dans lequel les couches céramiques (3) sont fabriquées en frittant des feuilles de céramique crues selon la revendication 2.

8. Composant électronique céramique multicouches comprenant une pluralité de couches céramiques (3) empilées les unes sur les autres, dans lequel les couches céramiques (3) sont fabriquées en frittant des feuilles de céramique crues selon la revendication 2, le composant électronique céramique multicouches comprenant en outre une couche de contrainte (5 ; 9) placée sur l'une des couches céramiques (3), la couche de contrainte (5 ; 9) contenant une poudre de céramique qui n'est pas sensiblement frittée à la température de frittage des feuilles de céramique crues.
